# EUROPÄISCHE PATENTSCHRIFT

(11) **EP 2 047 729 B1**
(45) Veröffentlichungstag und Bekanntmachung des Hinweises auf die Patenterteilung: **03.03.2010**
(21) Anmeldenummer: 07785069.1
(22) Anmeldetag: 30.07.2007
(51) Int. Cl.: H05K 7/20

(54) **VORRICHTUNG MIT LUFT-LUFT-WÄRMETAUSCHER ZUR BEREITSTELLUNG VON KÜHLLUFT FÜR EINEN ELEKTROSCHRANK**
APPARATUS WITH AN AIR/AIR HEAT EXCHANGER FOR PROVIDING COOLING AIR FOR AN ELECTRICAL CABINET
DISPOSITIF AVEC ÉCHANGEUR DE CHALEUR AIR-AIR POUR FOURNIR DE L'AIR DE REFROIDISSEMENT À UNE ARMOIRE ÉLECTRIQUE

(30) Priorität: 03.08.2006 CH 12452006
(43) Veröffentlichungstag der Anmeldung: 15.04.2009
(73) Patentinhaber: Almatec AG, 6170 Schüpfheim (CH); Runge, André, 18507 Grimmen (DE)
(72) Erfinder: RUNGE, André, 18507 Grimmen (DE); HERTLI, Alfred, 6072 Sachseln/OW (CH)
(74) Vertreter: Lauer, Joachim
(86) Internationale Anmeldenummer: PCT/CH2007/000374
(87) Internationale Veröffentlichungsnummer: WO 2008/014627

(56) Entgegenhaltungen:
- EP-A- 0 944 297
- EP-B- 1 374 332
- WO-A-02/37919
- DE-A1- 19 844 644
- DE-U1- 8 705 665
- DE-U1-202005 018 777
- US-B1- 7 054 155

## Beschreibung

### TECHNISCHES GEBIET

Die vorliegende Erfindung betrifft eine Vorrichtung mit Luft-Luft-Wärmetauscher zur Bereitstellung von Kühlluft für einen Elektroschrank, wobei die Kühlluft in einem ersten Luftstrom und Umgebungsluft in einem zweiten Luftstrom eine Wärmetauscherkassette durchströmt und die beiden Luftströme durch Lüfter erzeugt werden.

Unter dem Begriff "Elektroschrank" sollen hier ganz allgemein alle Arten von Schränken, Gehäusen, Kabinen oder Kästen verstanden werden, die zur Aufname von elektrischen oder elektronischen Geräten und/oder Installationen verwendet, bestimmt oder wenigstens geeignet sind. Die Kühlluft dient zur Entwärmung des Elektroschranks, um die in ihm enthaltenen Geräte und/oder Installationen vor Überhitzung zu schützen.

### STAND DER TECHNIK

Vorrichtungen der betrachteten Art sind in vielfältigen Ausführungen bekannt, wobei die Lüfter im allgemeinen Radiallüfter sind. Siehe z.B. die Dokumente DE2005018777 U1 und WO-A1-02/37919.

Die erforderliche Entwärmungsleistung der Vorrichtung hängt ab von der jeweiligen Anwendung, der Verlustleistung der in dem Elekroschrank jeweils vorhandenen Geräte und/oder Installationen sowie von äusseren Effekten wie der Umgebungstemperatur und/oder der Sonneneinstrahlung am Aufstellungsort. Die Anpassung der bekannten Vorrichtungen an die jeweils geforderte Entwärmungsleistung erfolgt zum einen durch geeignete Wahl der Abmessungen der Wärmetauscherkassette und zum anderen durch Einsatz geeignet grosser und leistungsfähiger Lüfter. Neben der Entwärmungsleistung spielt die von der Vorrichtung ausgehende Lärmemission eine wichtige Rolle, wobei der zulässige Emissionsgrenzwert von Standort zu Standort variieren kann. Die Lärmemission hängt ebenfalls von der Bauart und Dimensionierung der eingesetzten Komponenten ab.

Bei Elektroschränken variieren die Anforderungen an ihre Entwärmung und ihre zulässigen Emissionen in extrem weiten Grenzen. Für einen bestimmten Elektroschrank können sich diese Anforderungen zudem mit der Zeit erheblich ändern. So werden die Elektroschränke bei ihrer Aufstellung regelmässig nur teilweise bestückt, um eine Ausbaureserve zur Verfügung zu halten, wobei ein Ausbau ggf. erst Jahre später oder auch überhaupt nicht erfolgen kann. Der Entwärmungsbedarf steigt auch, wenn vorhandene Komponenten durch solche mit höherer Verlustleistung ersetzt werden. In den vielen Fällen wäre es unwirtschaftlich und aus energetischen Gründen nicht sinnvoll, die maximal zu erwartende Entwärmungsleistung bereits von vornherein zur Verfügung zu stellen.

Eine Veränderung der Leistungs- und/oder Emissionsparameter ist nach dem Stand der Technik mit dem Einsatz stets anderer Komponenten verbunden, was für die Hersteller dieser Geräte bedeutet, eine Vielzahl unterschiedlicher Komponenten zur Verfügung zu stellen und zu verwalten.

### DARSTELLUNG DER ERFINDUNG

Die vorliegende Erfindung stellt sich die Aufgabe, bezüglich dieses Nachteils Abhilfe zu schaffen und sieht hierzu eine Vorrichtung gemäss Patentanspruch 1 vor. Die erfindungsgemässe Vorrichtung weist demnach eine mit einer variablen Anzahl von baugleichen Wärmetauscherkassetten und einer variablen Anzahl von baugleichen Lüftern bestückbare Montageeinheit auf.

Bevorzugt kommen die baugleichen Wärmetauscherkassetten in der Montageeinheit parallel zueinander zur Anordnung. Auch können in der Montageeinheit in beiden Luftströmen bevorzugt jeweils mehrere Lüfter parallel und/oder in Serie zueinander angeordnet werden.

Einen grosse Variationsvielfalt bezüglich der Kombination von Wärmetauscherkassetten und Lüftern bei einfachem Aufbau ergibt sich, wenn gemäss einer weiteren bevorzugten Ausführungsform der Erfindung in der Montageeinheit in beiden Luftströmen jeweils ein Plenum zwischen der variablen Anzahl von Wärmetauscherkassetten und der variablen Anzahl von Lüftern vorhanden ist.

Gemäss noch einer bevorzugten Ausführungsform der Erfindung können in der Montageeinheit in beiden Luftströmen jeder Wärmetauscherkassette zugeordnet mindestens je zwei Lüfter in Serie angeordnet werden.

Lüfter, die in der Montageeinheit in beiden Luftströmen zueinander in Serie angeordnet werden können, sind bevorzugt in einer gemeinsamen Aufnahme, insbesondere durch Einstecken, montierbar.

In einer Montageeinheit ist weiter bevorzugt für jede darin einsetzbare Wärmetauscherkassette und jeden darin einsetzbaren Lüfter ein Montageplatz reserviert. Die nicht mit einer Wärmetauscherkassette oder einem Lüfter bestückten Montageplätze können dabei mit einem die Luftströmung über diese Montageplätze sperrenden Platzhalter versehen sein.

Anders als im Stand der Technik üblich werden als Lüfter bevorzugt Axiallüfter eingesetzt, unter anderem deshalb, weil sich diese platzsparend bei Bedaf in Serie anordnen lassen. Axiallüfter erzeugen auch weniger Lärm als vergleichbare Radiallüfter.

Schliesslich kann für alle in der Montageeinheit einsetzbaren Lüfter eine gemeinsame elektrische Energieversorgung und/oder eine gemeinsame elektronische Steuerung vorgesehen sein.

### KURZE ERLÄUTERUNG DER FIGUREN

Die Erfindung soll nachfolgend anhand eines Ausführungsbeispiels im Zusammenhang mit der Zeichnung näher erläutert werden. Es zeigen:
- Fig. 1: einen Schnitt durch eine Vorrichtung nach der Erfindung mit einer mit mehreren baugleichen Wärmetauscherkassetten und mehreren baugleichen Lüftern bestückbaren Montageeinheit;
- Fig. 2: einen Blick in Montagewanne der Montageeinheit in perspektivischer Ansicht bei voller Bestückung;
- Fig. 3: die Montagewanne beim Herausnehmen bzw. Einsetzen einer Wärmetauscherkassette sowie von Lüftern; und
- Fig. 4: die Montagewanne bei geringerer Bestückung sowie mit Platzhaltern für Wärmetauscherkassetten und Lüfter.

### WEGE ZUR AUSFÜHRUNG DER ERFINDUNG

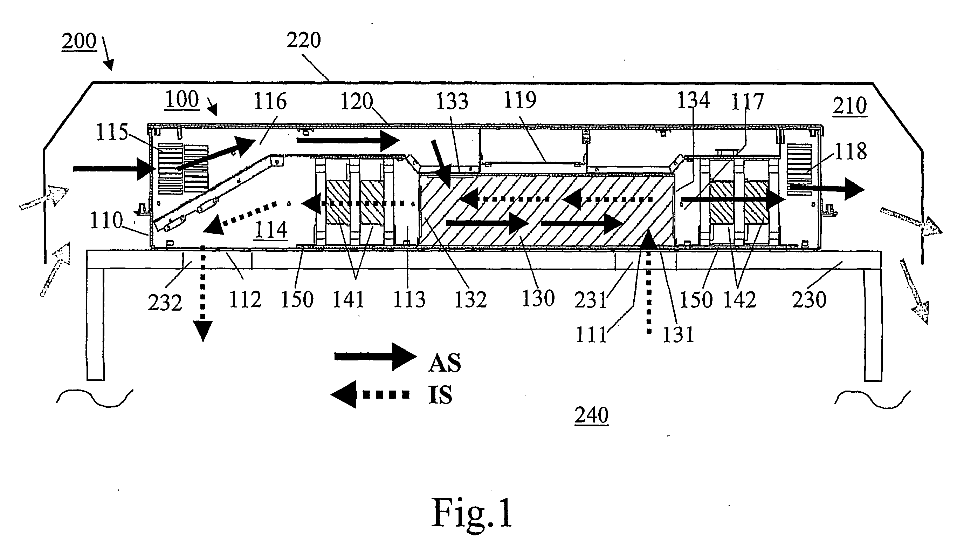

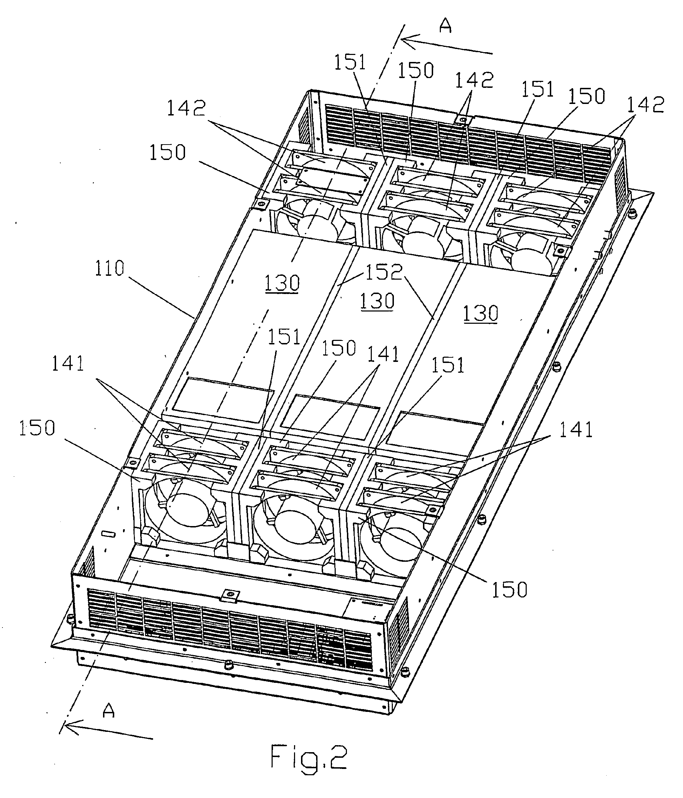

Fig. 1 zeigt eine Vorrichtung nach der Erfindung im Schnitt (A-A, Fig. 2), welche im Dachraum 210 unterhalb eines Oberdachs 220 eines lediglich schematisch sowie nur teilweise skizzierten Elektroschranks 200 angeordnet ist. Die erfindungsgemässe Vorrichtung ist auf einem Zwischendach 230 des Elektroschranks 200 angeordnet, das einen Innenraum 240 des Elektroschranks 200 nach oben abschliesst. In dem Innenraum 240 können wärmeempfindliche, ggf. Verlustwärme produzierende Geräte oder dergleichen enthalten sein, welche gekühlt werden müssen. Zur Bereitstellung von Kühlluft für den Innenraum 240 dient die erfindungsgemässe Vorrichtung, die dazu über Öffnungen 231 und 232 im Zwischendach 230 mit dem Innenraum 240 in Verbindung steht.

Die erfindungsgemässe Vorrichtung umfasst eine kastenförmige Montageeinheit 100 mit einer Montagewanne 110 und einem deckelartigen Oberteil 120. In die Montagewanne 110 ist eine Wärmetauscherkasette 130 eingesetzt, zu beiden Seiten von welcher je zwei handelsübliche Axiallüfter 141 bzw. 142 in Serie zueinander angeordnet sind. Die Wärmetauscherkassette 130 weist Kanäle zwischen einerseits einer ersten Lufteintrittsöffnung 131 und einer ersten Luftaustrittsöffnung 132 und andererseits einer zweiten Lufteintrittsöffnung 133 und einer zweiten Luftaustrittsöffnung 134 auf.

Im Boden der Montagewanne 110 sind mit den Öffnungen 231 und 232 im Zwischendach des Elektroschranks fluchtende Öffnungen 111 und 112 vorgesehen.

Die Öffnung 111 fluchtet zudem mit der Lufteintrittsöffnung 131 der Wärmetauscherkassette 130. Durch an der Unterseite des Oberteils 120 befestigte Zwischenwandungen ist der Innenraum der Montageeinheit in mehrere, gegeneinander abgedichtete Kammern 113, 114, 116 und 117 unterteilt.

Durch die so ausgebildete erfindungsgemässe Vorrichtung können zwei von den Lüftern 141 bzw. 142 erzeugte Luftströme IS und AS im Gegenstrom getrennt voneinander wie folgt strömen:

Im Luftstrom IS strömt erwärmte Luft aus dem Innenraum 240 durch die Öffnungen 231, 111 und 131 in die Wärmetauscherkassette 130 ein und nach Passage von dieser durch die Luftaustrittsöffnung 131, die Kammer 113, die Lüfter 141, die Kammer 114 und die Öffnungen 112 und 232 als Kühlluft zurück in den Innenraum 240. Im Luftstrom AS strömt kühle Umgebungsluft durch mit gitterartigen Öffnungen 115 versehene Seitenwandungen der Montagewanne 110, die Kammer 116 und die Lufteintrittsöffnung 133 in die Wärmetauscherkassette 130 ein und nach Passage von dieser durch die Kammer 117, die Lüfter 142 und durch mit gitterartigen Öffnungen 118 versehene Seitenwandungen wieder in die Umgebung aus. In der Wärmetauscherkassette 130 wird Wärme vom Luftstrom IS an den Luftstrom AS abgegeben.

Die Montageeinheit 100 ist mit mehreren untereinander baugleichen Wärmetauscherkassetten 130 und untereinander ebenfalls baugleichen Axiallüftern 141 bzw. 142 bestückbar. Gemäss dem Konzept der Erfindung wird eine Anpassung an die für die jeweilige Anwendung erforderliche Entwärmungsleistung durch eine geeignete, ggf. nur teilweise Bestückung der Montageeinheit 100 erreicht.

Fig. 2 zeigt einen Blick in die Montagewanne 110 der Vorrichtung 100 bei abgenommenem Deckel 120. Die Montageeinheit 100 ist hier voll bestückt, wobei sie für drei Wärmetauscherkassetten und diesen zugeordnet in jedem der beiden Luftströme IS und AS für je zwei Lüfter 141 bzw. 142 ausgelegt ist. Diese Auslegung ist bevorzugt, doch könnte die Zahl an Wärmetauscherkassetten und/oder an Lüftern auch anders gewählt sein. Die einzelnen Wärmetauscherkassetten und die ihnen jeweils zugeordneten Lüfter können zusammen als Wärmertauschermodule aufgefasst werden, durch welche die Luft jeweils wie oben beschrieben strömt. Relativ zueinander sind die Wärmetauschermodule parallel zueinander angeordnet. Allerdings ist die Luftführung durch sie nicht streng getrennt, da die oben beschriebenen Kammern 113, 114, 116 und 117 allen drei Modulen gemeinsam sind und insofern ein Plenum bilden.

Die Wärmetauscherkassetten 130 sind in die Montagewanne 110 in vorbereitete Montageplätze eingesetzt und mittels Matten 152 gegeneinander abgedichtet. Die Lüfter sind in der Montagewanne 110 in Aufnahmen 150 mechanisch gehalten, in denen sie paarweise in Serie ebenfalls nur eingesteckt sind. Die Montage und Demontage der Wärmetauscherkassetten und der Lüfter ist dadurch ohne die Verwendung von Werkzeug möglich. Die Aufnahmen 150 sind mittels Füllstücken 151 gegeneinander abgedichtet, so dass keine Luft an den Lüftern vorbei strömen kann. Nach oben sind sie durch das Oberteil abgedichet. Die Aufnahmen 150 und/oder die Füllstücke 151 sind vorzugsweise aus einem geschäumten Material so ausgeführt, so dass sie unerwünschte Schwingungen, die durch Betrieb der Lüfter entstehen können, dämpfen und damit verbundene Geräusche absorbieren. Die Querschnittsgrösse der Wärmetauscherkassetten 130 ist an die Querschnittsgrösse der Lüfter bzw. deren Aufnahmen 150 angepasst. Die Lüfter können beispielsweise die gängigen Masse (80 x 80) mm bis (225 x 225) mm haben.

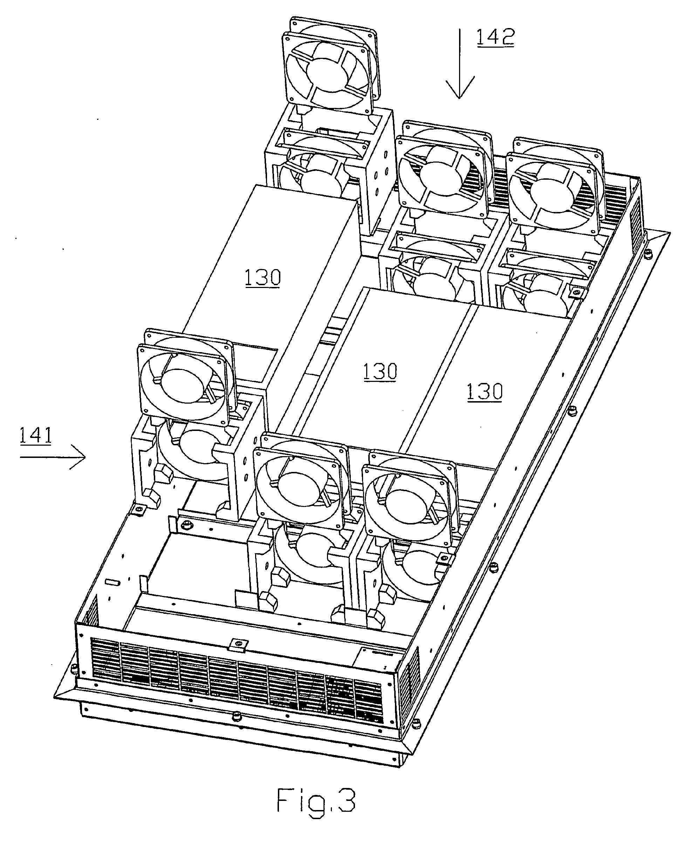

Fig. 3 zeigt die Montagewanne 110 beim Herausnehmen bzw. Einsetzen einzelner Komponenten wie einer der Wärmetauscherkassetten sowie von Lüftern.

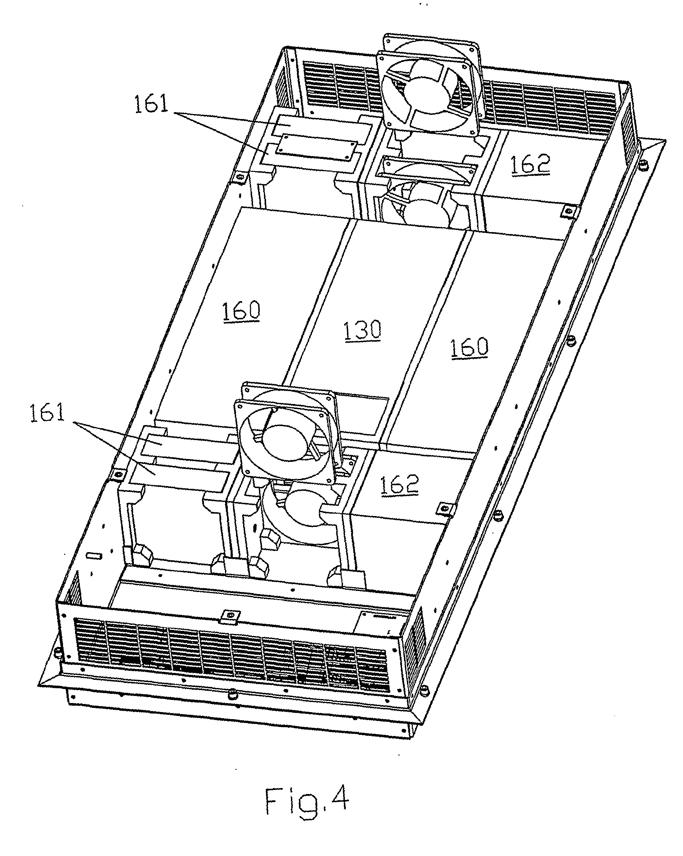

Nicht bestückte Montageplätze von Wärmetauscherkassetten und/oder Lüftern können, wie dies Fig. 4 zeigt, mit in sie eingesetzten Platzhaltern 160 bzw. 161 belegt werden, um den Luftweg über sie zu sperren. Bei den Platzhaltern kann es sich um einfache Blöcke aus einem geschäumten Material handeln. Anstelle von Platzhaltern für einzelne Lüfter könnten auch die Aufnahmen 150 mit entsprechende Platzhaltern 162 belegt sein, wie dies im rechten Wärmetauschermodul von Fig. 4 dargestellt ist.

Axiallüfter der in den Figuren dargestellten Art sind standardmässig mit einem kurzen Anschlusskabel mit Stecker versehen. Um diese Anschlussmöglichkeit auszunutzen, können in der Montagewanne 110 in der Nähe der Lüfter jeweils entsprechende Steckbuchsen (nicht dargestellt) gut zugänglich vorgesehen werden. Auch können die Füllstücke 151 so ausgeführt sein, dass die Kabel der Lüfter in ihnen geschützt geführt werden können. Zur Steuerung der Lüfter ist desweiteren eine zentrale, d.h. allen Lüftern gemeinsame elektronische Steuerung vorgesehen, von der eine Leiterplatte an der Unterseite des Deckels 220 angebracht und in Fig. 1 mit 119 bezeichnet ist. Die Steuerung kann beispielsweise ein Temperatur-Messsignal aus dem Innenraum 240 des Elekroschranks verwerten. Bevorzugt ist die Steuerung so ausgelegt, dass bei einer Änderung der Bestückung der Montageeinheit mit Wärmetauscherkassetten und/oder Lüftern keine Änderungen oder Anpassungen an ihr vorgenommen werden müssen.

Es versteht sich, dass Anpassungen der Zahl der Wärmetauscherkassetten und/oder der Zahl der Lüfter und damit Anpassungen der erfindungsgemässen Vorrichtung an die jeweils erforderliche Entwärmungsleitung äusserst einfach möglich sind und keine grundlegenden konstruktiven Veränderungen der Vorrichtung erfordern.

Indem sich die in Serie angeordneten Lüfter jeden Moduls in ihrer Wirkung ergänzen, bleibt der durch sie verursachte Luftstrom auch dann erhalten, wenn einer von ihnen ausfällt. Es reduziert sich dann lediglich der Volumenstrom. Wegen des erwähnten Plenums zwischen den Wärmetauscherkassetten und den Lüftern ergänzen sich zudem die parallel zueinander angeordneten Lüfter der verschiedenen Wärmetauschermodule. Die erfindungsgemässe Vorrichtung ist dadurch zu einem gewissen Grad redundant. Sofern in jedem der Luftströme IS und AS mehr als jeweils nur ein Lüfter vorhanden ist, führt ein Lüfterausfall nicht zum totalen kühltechnischen Ausfall der gesamten Vorrichtung. Durch geeignete Steuerung der einzelnen Lüfter kann ein Lüfterausfall in einem gewissen Umfang ggf. sogar ausgeglichen werden. Zum Teil ergibt sich das sogar selbsttätig über die Lüfterkennlinien. Umgekehrt kann vorgesehen sein, dass die Lüfter bei einem Ausfall der Steuerung automatisch, z.B. mit 80% ihrer Maxiamleistung, weiter laufen.

Die Variabilität der Bestückung der erfindungsgemässen Vorrichtung kann schliesslich dazu ausgenutzt werden, die Lärmemision der Vorrichtung zu reduzieren, wozu tendenziell grössere Querschnitte und niedrigere Strömungsgeschwindigkeiten geeignet sind.

Die erfindungsgemässe Vorrichtung muss nicht auf dem Dach oder in einem Dachraum eines Elektroschranks plaziert werden. Sie ist in gleicher Weise auch für eine Montage an einer Wand oder einer Tür des Elektroschranks geeignet, soweit die Platzverhältnisse dies im Einzelfall zulassen. Bei Dachmontage ist die erfindungsgemässe Vorrichtung in einer Ausbildung mit drei parallel nebeneinander plazierbaren Wärmetauschermodulen wie in den Figuren 2 - 4 dargestellt z.B. geeignet für Elektroschränke mit einer Tiefe ab 450 mm und einer Breite ab 850 mm. Für Elektroschänke mit z.B. nur 300 mm Tiefe kann die Vorrichtung mit zwei parallelen Wämetauschermodulen aufgebaut werden. Für Elektroschränke mit Breiten grösser als 2000 mm können zwei oder ggf. noch mehr erfindungsgemässe Vorrichtungen nebeneinander angeordnet werden.

### BEZEICHNUNGSLISTE

- 100: Montageeinheit
- 110: Montagewanne
- 111: Öffnungen im Boden der Montagewanne
- 112: Öffnungen im Boden der Montagewanne
- 113: Kammer
- 115: Kammer
- 114: Kammer
- 115: gitterartige Öffnungen
- 116: Kammer
- 117: Kammer
- 118: gitterartige Öffnungen
- 119: Leiterplatte einer Steuerung
- 120: deckelartiges Oberteil der Montagewanne
- 130: Wärmetauscherkassetten
- 131: erste Lufteintrittsöffnung
- 132: erste Luftaustrittsöffnung
- 133: zweite Lufteintrittsöffnung
- 134: zweite Luftaustrittsöffnung
- 141: Axiallüfter im Luftstrom IS
- 142: Axiallüfter im Luftstrom AS
- 150: Aufnahmen
- 151: Füllstücke
- 152: Matten
- 160: Platzhalter für Wärmetauscherkassetten
- 161: Platzhalter für Lüfter
- 162: Platzhalter für Aufnahmen
- 200: Elektroschrank
- 210: Dachraum
- 220: Oberdach
- 230: Zwischendach des Elektroschranks
- 231: Öffnungen im Zwischendach
- 232: Öffnungen im Zwischendach
- 240: Innenraum des Elektroschranks
- IS, AS: Luftströme

## Patentansprüche

1. Vorrichtung mit Luft-Luft-Wärmetauscher zur Bereitstellung von Kühlluft für einen Elektroschrank (200), wobei die Kühlluft in einem ersten Luftstrom (IS) und Umgebungsluft in einem zweiten Luftstrom (AS) eine Wärmetauscherkassette (130) durchströmen und die beiden Luftströme durch Lüfter (141, 142) erzeugt werden, **dadurch gekennzeichnet dass** sie eine mit einer variablen Anzahl von baugleichen Wärmetauscherkassetten (130) und einer variablen Anzahl von baugleichen Lüftern bestückbare Montageeinheit (100) aufweist.

2. Vorrichtung nach Anspruch 1, **dadurch gekennzeichnet, dass** die Wärmetauscherkassetten in der Montageeinheit parallel zueinander zur Anordnung kommen.

3. Vorrichtung nach Anspruch 1 oder 2, **dadurch gekennzeichnet, dass** in der Montageeinheit in beiden Luftströmen jeweils mehrere Lüfter parallel und/oder in Serie zueinander angeordnet werden können.

4. Vorrichtung nach einem der Ansprüche 1 - 3, **dadurch gekennzeichnet, dass** in der Montageeinheit in beiden Luftströmen jeweils ein Plenum zwischen der variablen Anzahl von Wärmetauscherkassetten und der variablen Anzahl von Lüftern vorhanden ist.

5. Vorrichtung nach einem der Ansprüche 1 - 4, **dadurch gekennzeichnet, dass** in der Montageeinheit in beiden Luftströmen jeder Wärmetauscherkassette zugeordnet mindestens je zwei Lüfter in Serie angeordnet werden können.

6. Vorrichtung nach einem der Ansprüche 3 - 5, **dadurch gekennzeichnet, dass** in der Montageeinheit in beiden Luftströmen Lüfter, die zueinander in Serie angeordnet werden können, in einer gemeinsamen Aufnahme, vorzugsweise durch Einstecken, montierbar sind.

7. Vorrichtung nach einem der Ansprüche 1 - 6, **dadurch gekennzeichnet, dass** in der Montageeinheit für jede darin einsetzbare Wärmetauscherkassette und jeden darin einsetzbaren Lüfter ein Montageplatz reserviert ist und dass mindestens einer der nicht mit einer Wärmetauscherkassette oder einem Lüfter bestückten Montageplätze mit einem die Luftströmung über diesen Montageplatz sperrenden Platzhalter versehen ist.

8. Vorrichtung nach einem der Ansprüche 1 - 7, **dadurch gekennzeichnet, dass** die Lüfter Axiallüfter sind.

9. Vorrichtung nach einem der Ansprüche 1 - 8, **dadurch gekennzeichnet, dass** für alle in der Montageeinheit einsetzbaren Lüfter eine gemeinsame elektrische Energieversorgung und/oder eine gemeinsame elektronische Steuerung vorhanden ist.

## Claims

1. Device with air-air heat exchanger for providing cooling air for an electrical cabinet (200), with the cooling air flowing through a heat exchanger cassette (130) in a first air flow (IS) and ambient air flowing through said heat exchanger cassette in a second air flow (AS), and with the two air flows being generated by fans (141, 142), **characterised in that** it has an assembly unit (100) that can be fitted with a variable number of structurally identical heat exchanger cassettes (130) and a variable number of structurally identical fans.

2. Device according to claim 1, **characterised in that** the heat exchanger cassettes are arranged in parallel with each other in the assembly unit.

3. Device according to claim 1 or 2, **characterised in that** several fans can be arranged in parallel and/or in series with each other in the assembly unit in each of the two air flows.

4. Device according to one of claims 1 to 3, **characterised in that** a plenum is available between the variable number of heat exchanger cassettes and the variable number of fans in the assembly unit in each of the two air flows.

5. Device according to one of claims 1 to 4, **characterised in that** at least two fans can be arranged in series in the assembly unit in both air flows, assigned to each heat exchanger cassette.

6. Device according to one of claims 3 to 5, **characterised in that** fans that can be arranged in series with each other can be mounted in the assembly unit in both air flows in a common receptacle, preferably by means of insertion.

7. Device according to one of claims 1 to 6, **characterised in that** an assembly space is reserved in the assembly unit for each heat exchanger cassette that can be inserted therein and for each fan that can be inserted therein, and that at least one of the assembly spaces that is not fitted with a heat exchanger cassette or fan is provided with a placeholder that blocks the air flow via this assembly space.

8. Device according to one of claims 1 to 7, **characterised in that** the fans are axial fans.

9. Device according to one of claims 1 to 8, **characterised in that** a common electrical power supply and/or a common electronic control is available for all fans that can be used in the assembly unit.

## Revendications

1. Dispositif avec échangeur de chaleur air-air pour la mise en attente d'air frais pour une armoire électrique (200), où une cassette d'échangeur de chaleur (130) est traversée par l'air frais en un premier flux d'air (IS) et par l'air ambiant dans un deuxième flux d'air (AS), et où les deux flux d'air sont produits par des ventilateurs (141, 142), **caractérisé en ce qu'**il présente une unité d'assemblage (100) pouvant être équipée d'un nombre variable de cassettes d'échangeur de chaleur (130) de même construction et d'un nombre variable de ventilateurs de même construction.

2. Dispositif selon la revendication 1, **caractérisé en ce que** les cassettes d'échangeur de chaleur se présentent dans l'unité d'assemblage dans une position parallèle les unes aux autres.

3. Dispositif selon l'une quelconque des revendications 1 ou 2, **caractérisé en ce que** plusieurs ventilateurs peuvent être montés en parallèle et/ou en série les uns avec les autres dans chacun des deux flux d'air au sein de l'unité d'assemblage.

4. Dispositif selon l'une quelconque des revendications 1 à 3, **caractérisé en ce qu'**une chambre d'accumulation est montée entre le nombre variable de cassettes d'échangeur de chaleur et le nombre variable de ventilateurs, dans chacun des deux flux d'air au sein de l'unité d'assemblage.

5. Dispositif selon l'une quelconque des revendications 1 à 4, **caractérisé en ce qu'**au moins deux ventilateurs peuvent être disposés pour chaque cassette d'échangeur de chaleur, dans les deux flux d'air au sein de l'unité d'assemblage.

6. Dispositif selon l'une quelconque des revendications 3 à 5, **caractérisé en ce que** des ventilateurs, agencés entre eux en série, peuvent être montés dans un logement commun, dans les deux flux d'air au sein de l'unité d'assemblage, de préférence par emboîtement.

7. Dispositif selon l'une quelconque des revendications 1 à 6, **caractérisé en ce qu'**un emplacement de montage est réservé au sein de l'unité d'assemblage pour chaque cassette d'échangeur de chaleur qui peut y être enfichée et pour chaque ventilateur qui peut y être enfiché, et **en ce qu'**au moins un des emplacements de montage non occupés par une cassette d'échangeur de chaleur ou par un ventilateur est muni d'un espaceur barrant le flux d'air dans cet emplacement de montage.

8. Dispositif selon l'une quelconque des revendications 1 à 7, **caractérisé en ce que** les ventilateurs sont des ventilateurs axiaux.

9. Dispositif selon l'une quelconque des revendications 1 à 8, **caractérisé en ce qu'**une alimentation électrique et/ou une commande électronique communes sont prévues pour tous les ventilateurs enfichables dans l'unité d'assemblage.
